Europäisches Patentamt

(19) European Patent Office (11) Veröffentlichungsnummer: **0 152 501**
**B1**
Office européen des brevets

(12) **EUROPÄISCHE PATENTSCHRIFT**

(45) Veröffentlichungstag der Patentschrift: (51) Int. Cl.⁴: **H 01 J 37/295, G 01 N 23/207**
12.04.89

(21) Anmeldenummer: 84101690.0

(22) Anmeldetag: 18.02.84

(54) Einrichtung zur Messung der Winkelverteilung von an einer Probenoberfläche gestreuten geladenen Teilchen.

(43) Veröffentlichungstag der Anmeldung: (73) Patentinhaber: **LEYBOLD AKTIENGESELLSCHAFT,**
28.08.85 Patentblatt 85/35 **Bonner Str. 504, D-5000 Köln 51 (DE)**

(45) Bekanntmachung des Hinweises auf die Patenterteilung: (72) Erfinder: **Henzler, Martin, Prof. Dr., Finkenweg 6,**
12.04.89 Patentblatt 89/15 **D-3008 Garbsen 5 (DE)**

(84) Benannte Vertragsstaaten: (74) Vertreter: **Leineweber, Jürgen, Dipl.-Phys.,**
CH DE FR GB IT LI **Nagelschmiedshütte 8, D-5000 Köln 40 (DE)**

(56) Entgegenhaltungen:
**JOURNAL OF APPLIED PHYSICS, Band 48, Nr. 12,**
**Dezember 1977, Seiten 5027-5032, American Institute of**
**Physics, New York, US; C. BERGER et al.: "Preliminary**
**study for the construction of a low-energy**
**electron-diffraction apparatus using high-tension**
**source"**
**PROCEEDINGS OF THE EUROPEAN CONGRESS ON**
**ELECTRON MICROSCOPY, Manchester, 5.-12.**
**September 1972, Proceedings 5, Seiten 58-59, Institute**
**of Physics, London, GB; W. KOCH et al.: "Combined**
**ultrahigh vacuum electron emission and low energy**
**electron diffraction mic roscopy"**
**OPTIK, Band 53, Nr. 4, Juli 1979, Seiten 281-284,**
**Wissenschaftliche Verlagsgesellschaft mbH, Stuttgart,**
**DE; T. SOMA: "A practical focus-deflection system for**
**shaped electron beams"**

## Beschreibung

Die Erfindung betrifft eine Einrichtung zur Messung der Winkelverteilung von an einer Probenoberfläche gestreuten geladenen Teilchen, bei der auf der Probe gegenüberliegenden Seite eines Ablenksystems, das die gestreuten Teilchen auf die Eintrittsöffnung eines dem genannten Ablenksystem nachgeordneten Detektors umlenkt, außer dem Detektor auch die Quelle zur Erzeugung des Primärteilchenstrahls angeordnet ist und bei der auch der Primärteilchenstrahl das Ablenksystem durchsetzt.

Einrichtungen dieser Art dienen zum Beispiel der Untersuchung von Kristalloberflächen nach der sogenannten LEED-Technik (Low Energy Electron Diffraction). Bei diesem Verfahren wird die Kristalloberfläche mit niederenergetischen Elektronen (20 bis 50 eV) beschossen. An den Strukturen der Kristalloberfläche treten Beugungserscheinungen auf, die zu Streuungen mit bevorzugten Richtungen führen. Die Feststellung dieser bevorzugten Richtungen kann durch Messung der Winkelverteilung der gestreuten Elektronen erfolgen. Eine andere Methode besteht darin, die gestreuten Elektronen mit Hilfe eines Leuchtschirmes sichtbar zu machen. Bei einer regelmäßigen Struktur der Kristalloberfläche entstehen regelmäßige Beugungsbilder, die sich aus einzelnen Beugungsreflexen zusammensetzen. Bei Abweichungen von der Regelmäßigkeit liegen Defekte der Oberflächenstruktur vor.

Bei einer aus Surface Science, 117 (1982), 180–187, bekannten Einrichtung ist die Anordnung der einzelnen Bauteile so getroffen, daß der Winkel zwischen dem einfallenden Teilchenstrahl und einem elastisch gestreuten Strahl 90° beträgt. Für Teilchenstrahlen, die bei einer Wechselwirkung mit der Oberfläche der Probe eine Beugung erfahren, weicht der Austrittswinkel von 90° ab. Das dem Detektor vorgelagerte Ablenksystem hat die Aufgabe, diese von der Richtung eines elastisch gestreuten Strahls abweichenden Teilchenstrahlen derart wahlweise umzulenken, daß sie auf die Eintrittsöffnung des nachgeordneten Detektors auftreffen. Dazu wird im Ablenksystem ein möglichst homogenes elektrisches Feld erzeugt, dessen Feldstärke und Richtung einstellbar sind. Die Feststellung der Winkelverteilung erfolgt durch entsprechendes Scannen. Die Größe des Abtastbereichs hängt zum einen von der Größe des in dem Ablenksystem herrschenden elektrischen Feldes homogener Feldverteilung und zum anderen vom Abstand der Probe zum Ablenksystem ab.

Aus dem Artikel «Combined Ultrahigh Vacuum Electron Emission and Low Energy Electron Diffraction Microscopy» von W. Koch, B. Bischoff und E. Bauer in Proc. Fifth European Congress on Electron Microscopy, 1972, ist eine Einrichtung der eingangs genannten Art bekannt. Das dabei verwendete Ablenksystem ist magnetischer Art, dessen Wirkung von der Orientierung des Geschwindigkeitsvektors der geladenen Teilchen abhängt. Dieses bedingt einen relativ großen Abstand zwischen Teilchenquelle und Detektor und damit einen voluminösen Aufbau.

Der vorliegenden Erfindung liegt die Aufgabe zugrunde, eine Einrichtung der eingangs genannten Art mit reduziertem Abstand zwischen Teilchenquelle und Detektor zu schaffen.

Erfindungsgemäß wird diese Aufgabe dadurch gelöst, daß das Ablenksystem ein Ablenkkondensator ist. Eine Einrichtung dieser Art ist im Vergleich zum Stand der Technik kompakter, da Teilchenquelle und Detektor unmittelbar nebeneinander angeordnet werden können. Außerdem kann – verglichen mit der aus Surface Science vorbekannten Einrichtung – der abtastbare Bereich des Beugungsbildes bei gegebenem maximalen Winkel mehr als verdoppelt werden. Dieser Vorteil wird ohne zusätzlichen. baulichen Aufwand erreicht.

Weitere Vorteile und Einzelheiten der Erfindung sollen anhand von in den Figuren dargestellten Ausführungsbeispielen erläutert werden.

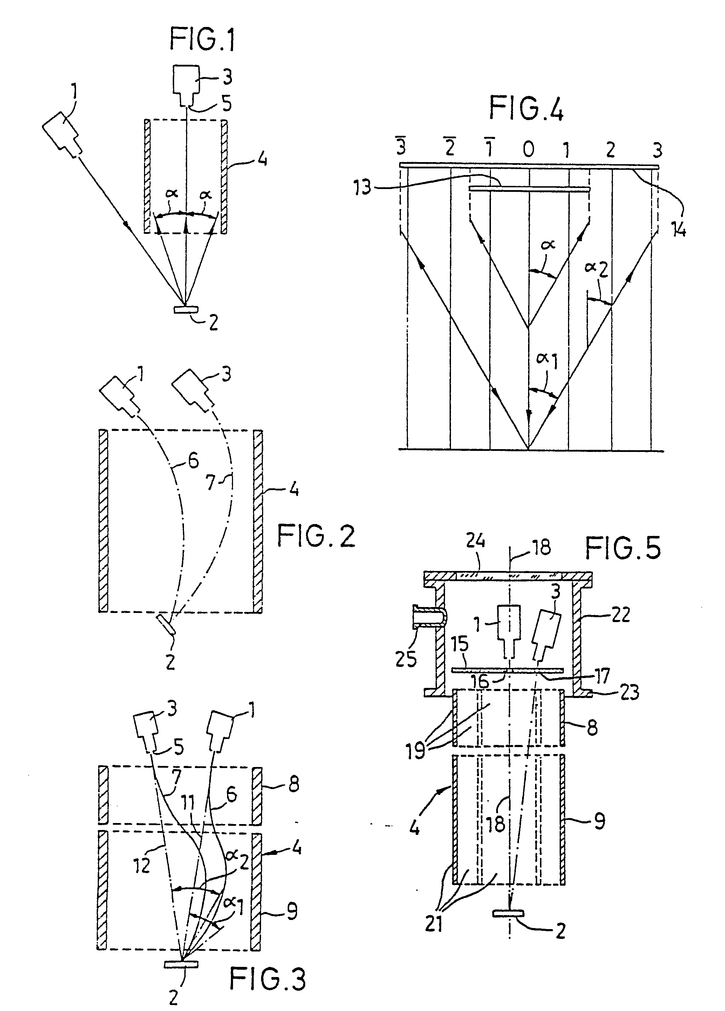

Fig. 1 zeigt eine Einrichtung nach dem Stand der Technik. Sie umfaßt die Teilchenquelle 1, mit der geladene Teilchen auf die Probe 2 gerichtet werden. Im Falle der Anwendung der LEED-Technik handelt es sich um Elektronen mit einer relativ niedrigen Energie. An der Oberfläche der Probe 2 erfahren die Elektronen eine Beugung und werden unter bevorzugten Winkeln α in Richtung des Detektors 3 gestreut. Dem Detektor 3 vorgelagert ist ein als Kondensator ausgebildetes Ablenksystem 4. Dieser hat die Aufgabe, die von der Probe 2 ausgehenden Teilchenstrahlen wahlweise auf die Eintrittsöffnung 5 des Detektors 3 abzubilden. Dadurch wird eine Messung der Winkelverteilung der von der Probe 2 gestreuten Teilchen bzw. Elektronen möglich, ohne daß eine mechanische Bewegung des Kristalls 2 (Drehung) oder des Detektors 3 (Verschwenkung) erforderlich ist. Die Anordnung ist nicht nur für die LEED-Technik, sondern auch für Fotoemissionsmessungen brauchbar, bei der die winkelabhängige Emission wesentliche Informationen z.B. über die Bandstruktur von Kristallen liefert.

Fig. 2 zeigt ein Ausführungsbeispiel nach der Erfindung. Mit 1 und 3 sind wieder die Teilchenquelle und der Detektor bezeichnet. Die Anordnung dieser Elemente in bezug auf das Ablenksystem 4 ist so getroffen, daß sowohl der Primärstrahl 6 als auch die gestreuten Teilchenstrahlen 7 das Ablenksystem 4 durchsetzen. Infolge des durch das Ablenksystem 4 erzeugten elektrischen Feldes erfahren sowohl Primärstrahl 6 als auch Sekundärstrahl 7 eine Ablenkung. Es ist deshalb zweckmäßig, Quelle 1, Detektor 3 und auch die Probe 2 entsprechend auszurichten.

Beim Ausführungsbeispiel nach Fig. 3 ist das Ablenksystem 4 geteilt. Es besteht aus den Abschnitten 8 und 9 mit etwa inverser Spannungsversorgung. Die Spannungen sind so gewählt, daß der Primärstrahl 6 zunächst von der Richtung der direkten Verbindungslinie 11 zwischen der Teilchenquelle 1 und der Probe 2 abgelenkt wird. Im zweiten Abschnitt 9 erfährt er eine entgegengesetzte Ablenkung, so daß der Primärstrahl 6 unter

dem Winkel $\alpha_1$ (in bezug auf die direkte Verbindungslinie 11) auf die Probe 2 auftrifft.

Die Teilchenbahn 7 ist ein Beispiel für einen der verschiedenen Teilchenstrahlen, die mit bevorzugter Richtung an der Probenoberfläche gestreut werden. Der Teilchenstrahl 7 verläßt die Probe 2 in bezug auf die direkte Verbindungslinie 12 zwischen der Probe 2 und der Eintrittsöffnung 5 des Detektors 3 unter dem Winkel $\alpha_2$ und wird im Abschnitt 9 des Ablenksystems 4 zu dieser Verbindungslinie hin abgelenkt. Im Abschnitt 8 ändert sich die Ablenkrichtung derart, daß der Sekundärstrahl 7 senkrecht auf die Eintrittsöffnung 5 des Detektors 3 auftrifft. Teilchenquelle 1 und Detektor 3 sind bei dieser Lösung etwa gleich weit von der Achse des Systems entfernt.

In Fig. 4 ist anhand der Darstellung des nutzbaren Bereichs im Beugungsbild (reziproker Raum) verdeutlicht, welcher Fortschritt durch die Erfindung erzielt wird, und zwar durch die Anordnung nach Fig. 3 im Vergleich zum Stand der Technik nach Fig. 1. Dargestellt sind die Winkel $\alpha$ (aus Fig. 1) sowie die Winkel $\alpha_1$ und $\alpha_2$ (aus Fig. 3). Die vertikalen Linien geben jeweils die Beugungsordnungen an. In dieses Bild sind die nutzbaren Bereiche nach dem Stand der Technik (Linie 13) und nach dem Ausführungsbeispiel nach Fig. 3 (Linie 14) eingetragen. Es ist ersichtlich, daß der durch die Erfindung erzielte abtastbare Bereich 14 wegen der Ablenkung sowohl des einfallenden als auch des gebeugten Strahls mehr als doppelt so groß ist als der abtastbare Bereich 13 nach dem Stand der Technik.

Schließlich zeigt Fig. 5 eine Lösung, bei der zusätzlich noch ein Leuchtschirm 15 zwischen dem Ablenksystem 4 und der Teilchenquelle 1 angeordnet ist. Dieser weist Durchbrechungen 16, 17 für die Teilchenstrahlen auf. Das Ablenksystem 4 besteht wieder aus zwei Abschnitten 8 und 9, die ihrerseits aus jeweils acht um die Achse 18 des Systems rotationssymmetrisch (tangential) angeordneten Platten 19, 21 bestehen. Soll die Winkelverteilung der an der Oberfläche der Probe 2 gestreuten Teilchen mit Hilfe des Detektors 3 gemessen werden, dann werden die Spannungen an den Abschnitten 8 und 9 so gewählt, wie es zu Fig. 3 beschrieben wurde. Sollen die Beugungsbilder mit Hilfe des Leuchtschirmes 15 sichtbar gemacht werden, dann werden sämtliche Ablenkplatten 19 und 21 auf Erdpotential gelegt.

Die einzelnen Bauteile 1, 3, 15, 19, 21 sind in nicht näher dargestellter Weise an einem Gehäuse 22 gehalten, das mit einem Flansch 23 ausgerüstet ist und damit auf einen Rezipienten aufsetzbar ist, in dem sich die Probe 2 befindet. Auf der dem Flansch 23 abgewandten Seite bildet ein Fenster 24 den Abschluß des Gehäuses 22, so daß der Leuchtschirm 15 sichtbar bleibt. Die Teilchenquelle 1 ist auf der Achse 18 des Systems, der Detektor 3 seitlich davon angeordnet. Dadurch ist nur ein geringer Teil des Leuchtschirmes 15 verdeckt. Durch Drehen des Ablenkfeldes im Ablenkkondensator 4 können die durch die Bauteile 1 und 3 zunächst verdeckten Beugungsbilder sichtbar gemacht werden. Über einen Anschlußstutzen 25 ist das Gehäuse 22 an eine Vakuumpumpe anschließbar.

## Patentansprüche

1. Einrichtung zur Messung der Winkelverteilung von an einer Probenoberfläche gestreuten geladenen Teilchen, bei der auf der der Probe (2) gegenüberliegenden Seite eines Ablenksystems (4), das die gestreuten Teilchen auf die Eintrittsöffnung eines dem genannten Ablenksystem nachgeordneten Detektors (3) umlenkt, außer dem Detektor auch die Quelle (1) zur Erzeugung des Primärteilchenstrahls angeordnet ist und bei der auch der Primärteilchenstrahl das Ablenksystem durchsetzt, dadurch gekennzeichnet, daß das Ablenksystem ein Ablenkkondensator ist.

2. Einrichtung nach Anspruch 1, dadurch gekennzeichnet, daß der Ablenkkondensator (4) in seiner Längsrichtung in zwei Abschnitte (8, 9) geteilt ist.

3. Einrichtung nach Anspruch 1 oder 2, dadurch gekennzeichnet, daß der Ablenkkondensator (4) oder seine beiden Abschnitte (8, 9) je acht rotationssymmetrisch angeordnete Ablenkplatten (19, 21) umfaßt.

4. Einrichtung nach Anspruch 1, 2 oder 3, dadurch gekennzeichnet, daß der Detektor (3) und die Teilchenquelle (1) nebeneinander angeordnet sind.

5. Einrichtung nach Anspruch 4, dadurch gekennzeichnet, daß die Positionen des Detektors (3) und der Teilchenquelle (1) um etwa den gleichen Betrag von der Achse des Ablenkkondensators (4) entfernt sind.

6. Einrichtung nach Anspruch 4, dadurch gekennzeichnet, daß die Teilchenquelle (1) oder der Detektor (3) auf der Achse des Ablenkkondensators (4) angeordnet sind.

7. Einrichtung nach einem der vorhergehenden Ansprüche, dadurch gekennzeichnet, daß zwischen dem Ablenkkondensator (4) einerseits und der Teilchenquelle (1) und dem Detektor (3) andererseits ein mit Durchtrittsöffnungen (16, 17) ausgerüsteter Leuchtschirm (15) angeordnet ist.

8. Einrichtung nach Anspruch 7, dadurch gekennzeichnet, daß sich der Leuchtschirm (15) in einem Gehäuse (22) befindet, das mit einem vakuumdichten Fenster (24) für die Betrachtung des Leuchtschirms (15) ausgerüstet ist.

## Claims

1. A device for measuring the angular distribution of charged particles scattered on a sample surface, wherein on the side of a deflecting system (4) opposite the sample (2), which deflecting system deflects the scattered particles onto the entrance opening of a detector (3) arranged downstream of the above-mentioned deflecting system, in addition to the detector there is also arranged the source (1) for generating the primary particle beam and wherein the primary particle beam also passes through the deflecting system, characterized in that the deflecting system is a deflecting capacitor.

2. A device according to claim 1, characterized in that the deflecting capacitor (4) is divided in the longitudinal direction into two sections (8, 9).

3. A device according to claim 1 or claim 2, characterized in that the deflecting capacitor (4) or its two sections (8, 9) each comprise eight rotationally symmetrically arranged deflecting plates (19, 21).

4. A device according to any one of claims 1 to 3, characterized in that the detector (3) and the particle source (1) are arranged next to each other.

5. A device according to claim 4, characterized in that the positions of the detector (3) and the particle source (1) are separated from the axis of the deflecting capacitor (4) by approximately the same amount.

6. A device according to claim 4, characterized in that the particle source (1) or the detector (3) is arranged on the axis of the deflecting capacitor (4).

7. A device according to any one of the preceding claims, characterized in that between the deflecting capacitor (4) on the one hand and the particle source (1) and the detector (3) on the other hand there is arranged a luminescent screen (15) provided with perforations (16, 17).

8. A device according to claim 7, characterized in that the luminescent screen (15) is located in a housing (22) which is equipped with a vacuum-tight window (24) for observation of the luminescent screen (15).

**Revendications**

1. Dispositif pour la mesure de la distribution angulaire de particules chargées diffractées sur la surface d'un échantillon, dans lequel, non seulement le détecteur placé en aval du système de déviation (4) servant à dévier les particules réfractées vers l'orifice d'entrée du détecteur (3), mais aussi la source (1) servant à engendrer le faisceau de particules primaires sont disposés du côté de ce système de déviation (4) qui est à l'opposé de l'échantillon (2), et dans lequel le faisceau de particules primaires traverse le système de déviation, caractérisé en ce que le système de déviation est un condensateur de déviation.

2. Dispositif selon la revendication 1, caractérisé en ce que le condensateur de déviation (4) est divisé en deux segments (8, 9) dans sa direction longitudinale.

3. Dispositif selon la revendication 1 ou 2, caractérisé en ce que le condensateur de déviation (4), ou chacun de ces deux segments (8, 9) comprend huit plaques de déviation (19, 21) placées dans une disposition possédant une symétrie de révolution.

4. Dispositif selon la revendication 1, 2 ou 3, caractérisé en ce que le détecteur (3) et la source de particules (1) sont disposés l'un à côté de l'autre.

5. Dispositif selon la revendication 4, caractérisé en ce que les positions du détecteur (3) et de la source de particules (1) sont espacées de l'axe du condensateur de déviation (4) de distances à peu près égales.

6. Dispositif selon la revendication 4, caractérisé en ce que la source de particules (1) ou le détecteur (3) est disposé(e) sur l'axe du condensateur de déviation (4).

7. Dispositif selon l'une des revendications précédentes, caractérisé en ce qu'un écran luminescent (15) muni d'ouvertures de passage (16, 17) est disposé entre le condensateur de déviation (4) et l'ensemble composé de la source de particules (1) et du détecteur (3).

8. Dispositif selon la revendication 7, caractérisé en ce que l'écran luminescent (15) est placé dans un boîtier (22) équipé d'une fenêtre étanche au vide (24) qui permet d'observer l'écran luminescent (15).

FIG.1

FIG.4

FIG.2

FIG.5

FIG.3